# EUROPÄISCHE PATENTANMELDUNG

(11) **EP 1 452 877 A1**
(43) Veröffentlichungstag der Anmeldung: **01.09.2004**
(21) Anmeldenummer: 03405137.5
(22) Anmeldetag: 28.02.2003
(51) Int. Cl.: G01R 15/18, H02M 7/00

(54) **Kurzschlussdetektion in einer Umrichterschaltung**

(71) Anmelder: ABB Schweiz AG, 5400 Baden (CH)
(72) Erfinder: Knapp, Gerold, 5408 Ennetbaden (CH); Mauron, Pascal, 3982 Überstorf (CH); Stemmler, Christoph, 5402 Baden (CH)
(74) Vertreter: ABB Patent Attorneys

(57) **Zusammenfassung**

Es wird eine Umrichterschaltung mit einem für jede Phase (R, S, T) vorgesehenen und über eine Verschienung (1) parallel zu einem Gleichspannungskreis geschalteten Zweigpaar angegeben, wobei jedes Zweigpaar aus mindestens zwei in Serie geschalteten Leistungshalbleiterschaltern gebildet ist. Zur Kurzschlussstromdetektion umfasst die Umrichterschaltung eine Einrichtung, wobei die Einrichtung eine Erfassungseinheit und eine für jedes Zweigpaar vorgesehene und mit der Erfassungseinheit verbundene Messschleife (7) aufweist. Die Messschleife (7) ist derart angeordnet, dass ein durch einen in der Verschienung (1) und in den Leistungshalbleiterschaltern des zugehörigen Zweigpaares fressenden Strom (I) erzeugtes Magnetfeld (H) eine von einer Windung (8) der Messschleife (7) eingeschlossene Fläche (A) zumindest teilweise durchdringt.

## Beschreibung

### Technisches Gebiet

Die Erfindung bezieht sich auf das Gebiet der Leistungselektronik. Sie geht aus von einer Umrichterschaltung gemäss dem Oberbegriff des unabhängigen Anspruchs.

### Stand der Technik

Ansteuerbare Leistungshalbleiterschalter werden derzeit vermehrt in der Umrichtertechnik und insbesondere in Umrichterschaltungen für elektrische Antriebe oder Netzkopplungen eingesetzt. Die ansteuerbaren Leistungshalbleiterschalter werden über ihre Ansteuerelektrode mit Hilfe einer Ansteuerschaltung durch Anlegen eines entsprechenden Ansteuersignals angesteuert. Gängigerweise bilden bei einer eingangs erwähnte Umrichterschaltung mindestens zwei in Serie geschaltete ansteuerbare Leistungshalbleiterschalter ein Zweigpaar, wobei ein solches Zweigpaar für jede Phase der Umrichterschaltung vorgesehen ist. Jedes Zweigpaar ist zudem über eine Verschienung parallel an einen Gleichspannungskreis angeschlossen. Ein solches Zweigpaar ist beispielsweise in der DE 195 21 108 A1 angegeben.

Bei Fehlerfällen in einem Zweigpaar nach der DE 195 21 108 A1 kann ein Kurzschluss im Hauptstrompfad des jeweiligen ansteuerbaren Leistungshalbleiterschalters, d.h. zwischen der Anode und Kathode des jeweiligen ansteuerbaren Leistungshalbleiterschalters auftreten. Im Kurzschlussfall steigt dabei der Strom im Hauptstrompfad sehr schnell auf eine hohe Stromamplitude an, so dass das Stromintegral über der Zeit unzulässig hohe Werte annimmt. Zur Detektion eines solchen Kurzschlussstromes in der Umrichterschaltung, insbesondere in einem Zweigpaar, ist in der DE 195 21 108 A1 zwischen den ansteuerbaren Leistungshalbleiterschaltern mindestens eine diskrete Induktivität in Serie geschaltet, die mit einer Einrichtung zur Kurzschlussstromdetektion magnetisch gekoppelt ist. Diese Einrichtung weist eine Erfassungseinheit und eine für jedes Zweigpaar vorgesehene und mit der Erfassungseinheit verbundene Messschleife auf, wobei die vorstehend angesprochene magnetische Kopplung zwischen der Induktivität und der Messschleife gegeben ist. Tritt nun ein Kurzschlussstrom beispielsweise in einem oder mehreren der ansteuerbaren Leistungshalbleiterschalter eines Zweigpaars auf, so wird durch die Änderung des Magnetfeldes der Induktivität eine Spannung in der Messschleife induziert. Diese zu dem auftretenden Kurzschlussstrom korrespondierende Spannung wird der Erfassungseinheit zugeführt, in der die Spannung erfasst wird, wobei die Spannung in einer der Erfassungseinheit nachgeschalteten Auswerteeinrichtung zur Weiterverarbeitung, insbesondere zur Einleitung von Massnahmen gegen den auftretenden Kurzschlussstrom ausgewertet wird.

Problematisch bei einer Umrichterschaltung, insbesondere bei einem Zweigpaar nach der DE 195 21 108 A1 ist, dass in der Umrichterschaltung, insbesondere in einem Zweigpaar mindestens eine diskrete Induktivität benötigt wird, um überhaupt einen Kurzschlussstrom detektieren zu können. Eine solche Induktivität ist aber teuer und benötigt entsprechend viel Platz. Zudem ist durch die mindestens eine Induktivität kein niederinduktiver Aufbau der Umrichterschaltung, wie heute vermehrt gefordert, erreichbar.

### Darstellung der Erfindung

Aufgabe der Erfindung ist es deshalb, eine Umrichterschaltung anzugeben, bei welcher ein Kurzschlussstrom in einem Zweigpaar mit möglichst wenigen Bauelementen detektiert werden kann und die zudem niederinduktiv, unkompliziert und kostengünstig aufgebaut ist und mit einem geringen Platzbedarf auskommt. Diese Aufgabe wird durch die Merkmale des Anspruchs 1 gelöst. In den abhängigen Ansprüchen sind vorteilhafte Weiterbildungen der Erfindung angegeben.

Die erfindungsgemässe Umrichterschaltung weist ein für jede Phase vorgesehenes und über eine Verschienung parallel zu einem Gleichspannungskreis geschaltetes Zweigpaar auf, wobei jedes Zweigpaar aus mindestens zwei in Serie geschalteten Leistungshalbleiterschaltern gebildet ist. Weiterhin ist eine Einrichtung zur Kurzschlussstromdetektion vorgesehen, wobei die Einrichtung eine Erfassungseinheit und eine für jedes Zweigpaar vorgesehene und mit der Erfassungseinheit verbundene Messschleife aufweist. Erfindungsgemäss ist die Messschleife derart angeordnet, dass ein durch einen in der Verschienung und in den Leistungshalbleiterschaltern des zugehörigen Zweigpaares fliessenden Strom erzeugtes Magnetfeld eine von einer Windung der Messschleife eingeschlossene Fläche zumindest teilweise durchdringt. Tritt ein Kurzschlussstrom beispielsweise in einem oder mehreren der Leistungshalbleiterschalter eines Zweigpaars auf, so ändert sich das von der stromführenden Verschienung und dem stromführenden Leistungshalbleiterschalter ausgehende Magnetfeld. Da die Messschleife erfindungsgemäss derart angeordnet ist, dass das Magnetfeld die von einer Windung der Messschleife eingeschlossene Fläche zumindest teilweise durchdringt, wird durch die Änderung des Magnetfeldes bei einem auftretenden Kurzschlussstrom vorteilhaft eine Spannung in der Messschleife induziert. Diese zu dem auftretenden Kurzschlussstrom korrespondierende Spannung wird dann in der Erfassungseinheit erfasst und somit detektiert. Die erfindungsgemässe Anordnung der Messschleife kommt ohne zusätzliche und aus dem Stand der Technik bekannte Induktivität aus, so dass mit Vorteil ein unkomplizierter und kostengünstig Aufbau der Umrichterschaltung realisierbar ist, wobei die Umrichterschaltung zudem mit einem geringen Platzbedarf auskommt. Darüber hinaus ist durch vorstehend beschriebene Anordnung der Messschleife vorteilhaft eine Kurzschlussstromdetektion auch in einer sehr niederinduktiv aufgebauten Umrichterschaltung möglich, ohne dass zusätzlich Induktivitäten eingefügt werden müssen.

Diese und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

### Kurze Beschreibung der Zeichnungen

Es zeigen:
- Fig. 1: ein schematisches Schaltbild einer erfindungsgemässen Umrichterschaltung,
- Fig. 2a: eine Aufsicht eines Ausschnitts einer ersten Ausführungsform der erfindungsgemässen Umrichterschaltung,
- Fig. 2b: eine Explosionsansicht des Ausschnitts der ersten Ausführungsform nach Fig. 2a der erfindungsgemässen Umrichterschaltung,
- Fig. 3: eine Aufsicht eines Ausschnitts einer zweiten Ausführungsform der erfindungsgemässen Umrichterschaltung,
- Fig. 4a: eine Vorderansicht eines Ausschnitts einer dritten Ausführungsform der erfindungsgemässen Umrichterschaltung und
- Fig. 4b: eine Aufsicht eines Ausschnitts einer vierten Ausführungsform der erfindungsgemässen Umrichterschaltung.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebene Ausführungsform steht beispielhaft für den Erfindungsgegenstand und hat keine beschränkende Wirkung.

### Wege zur Ausführung der Erfindung

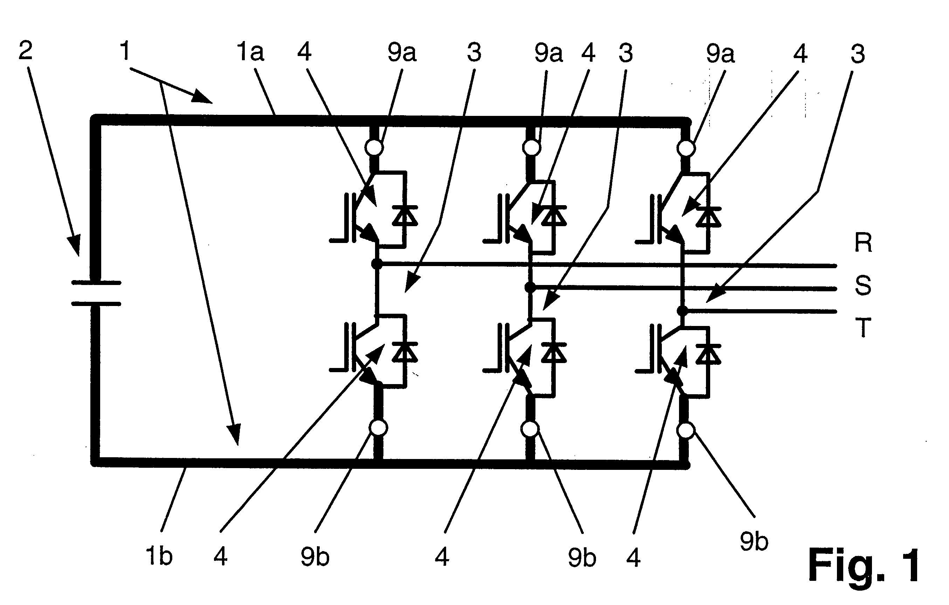

In Fig. 1 ist ein schematisches Schaltbild einer erfindungsgemässen Umrichterschaltung gezeigt. Die Umrichterschaltung gemäss Fig. 1 isf beispielhaft dreiphasig ausgeführt, kann aber allgemein beliebig viele Phasen R, S, T aufweisen. Für jede Phase R, S, T ist ein Zweigpaar 3 vorgesehen, welches über eine Verschienung 1 parallel zu einem Gleichspannungskreis 2 geschaltet ist. Der Gleichspannungskreis ist gemäss Fig. 1 durch einen Kondensator gebildet, kann aber allgemein auch durch eine Vielzahl von vorzugsweise in Serie oder parallel geschalteten Kondensatoren gebildet sein. Gemäss Fig. 1 ist jedes Zweigpaar 3 ferner aus mindestens zwei in Serie geschalteten Leistungshalbleiterschaltern 4 gebildet. Vorzugsweise ist jeder Leistungshalbleiterschalter 4 als ansteuerbarer bidirektionaler Leistungshalbleiterschalter 4, insbesondere wie in Fig. 1 gezeigt als Bipolartransistor mit isoliert angeordneter Ansteuerelektrode mit zusätzlich antiparallel geschalteter Diode ausgeführt. Selbstverständlich ist es auch denkbar, dass ein solcher vorstehend genannter ansteuerbarer bidirektionaler Leistungshalbleiterschalter 4 beispielsweise als Abschaltthyristor, wie beispielweise GTO oder IGCT mit entsprechender Beschaltung, oder als Leistungs-MOSFET mit antiparallel geschalteter Diode ausgeführt sein kann. Die Verschienung 1 weist gemäss Fig. 1 zwei Verschienungsstränge 1a, 1b auf, die vorzugsweise jeweils plattenförmig ausgeführt sind und ein elektrisch leitendes Material enthalten. Allgemein ist die erfindungsgemässe Umrichterschaltung aber nicht auf zwei Verschienungsstränge 1 a, 1 b beschränkt, sondern es ist auch eine Vielzahl an Verschienungssträngen der Verschienung 1 für die erfindungsgemässe Umrichterschaltung denkbar. Der besseren Erkennbarkeit halber sind die Verschienung 1 beziehungsweise die Verschienungsstränge 1a, 1b im schematisches Schaltbild der erfindungsgemässen Umrichterschaltung gemäss Fig. 1 mit einer dickeren Linie dargestellt. Gemäss Fig. 1 weist jeder Verschienungsstrang 1a, 1b jeweils einen Verschienungsanschluss 9a, 9b für die Leistungshalbleiterschalter 4 eines jeden Zweigpaars 3 auf, wobei die Zweigpaare 3 gemäss Fig. 1 an den jeweiligen Verschienungsanschlüssen 9a, 9b zueinander und zu dem Gleichspannungskreis 2 parallel geschaltet sind. Vorzugsweise ist der jeweilige Verschienungsanschluss 9a, 9b einstückig mit dem zugehörigen Verschienungsstrang 1a, 1 b ausgebildet und verläuft im wesentlichen senkrecht zur Ausdehnungsrichtung X des zugehörigen Verschienungsstranges 1a, 1b. Die Verbindung eines jeden Leistungshalbleiterschalters 4 am zugehörigen Verschienungsanschluss 9a, 9b des entsprechenden Zweigpaars 3 ist im Inneren des Gehäuses des Leistungshalbleiters 4 fortgeführt, d.h. mindestens eine Leistungshalbleiterschalterleiterbahn innerhalb des Gehäuses eines jeden Leistungshalbleiterschalters 4 ist mit einem der Verschienungsanschlüsse 9a, 9b des zugehörigen Zweigpaars 3 verbunden.

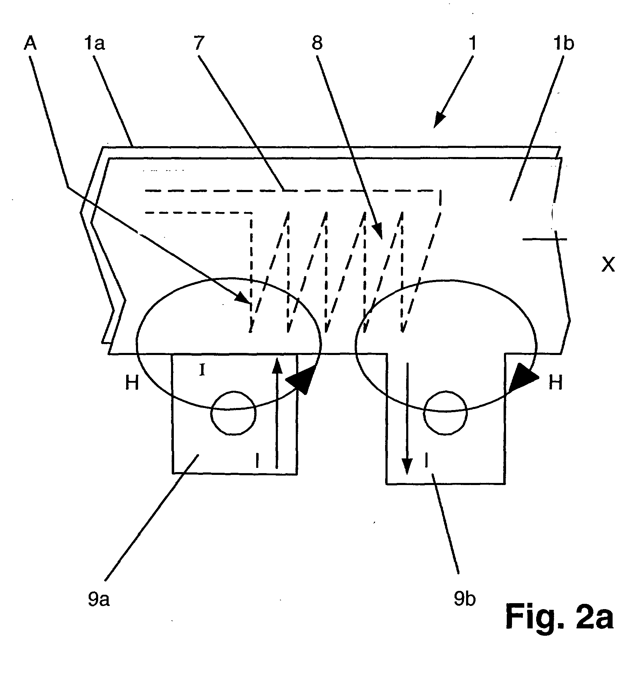

Die erfindungsgemässe Umrichterschaltung umfasst ferner eine Einrichtung zur Kurzschlussstromdetektion, wobei die Einrichtung eine Erfassungseinheit 6 und eine für jedes Zweigpaar 3 vorgesehene und mit der Erfassungseinheit 6 verbundene Messschleife 7 aufweist. Die Einrichtung zur Kurzschlussstromdetektion ist in Fig. 1 der Übersichtlichkeit nicht gezeigt. Die Einrichtung zur Kurzschlussstromdetektion, insbesondere die Messschleife 7 und deren Anordnung ist in den Ausführungsformen der erfindungsgemässen Umrichterschaltung nach Fig. 2a bis Fig. 4b dargestellt, wobei auf diese Ausführungsformen nachfolgend detailliert eingegangen wird.

Erfindungsgemäss ist die Messschleife 7 der Einrichtung zur Kurzschlussstromdetektion derart angeordnet, dass ein durch einen in der Verschienung 1 und in den Leistungshalbleiterschaltern 4 des zugehörigen Zweigpaares 3 fliessenden Strom I erzeugtes Magnetfeld H eine von einer Windung 8 der Messschleife 7 eingeschlossene Fläche A zumindest teilweise durchdringt. Bei einem auftretenden Kurzschlussstrom, insbesondere bei einer auftretenden Stromänderung, in einem Zweigpaar 3 beispielsweise durch einen Kurzschluss in einem oder mehreren der Leistungshalbleiterschalter 4 dieses Zweigpaars 3 ändert sich das von der stromführenden Verschienung 1 und dem stromführenden Leistungshalbleiterschalter 3 ausgehende Magnetfeld H. Da die Messschleife 7 erfindungsgemäss derart angeordnet ist, dass das Magnetfeld H die von einer Windung 8 der Messschleife 7 eingeschlossene Fläche A zumindest teilweise durchdringt, wird durch die Änderung des Magnetfeldes H bei einem auftretenden Kurzschlussstrom vorteilhaft eine Spannung in der Messschleife 7 induziert. Diese zu dem auftretenden Kurzschlussstrom korrespondierende Spannung wird dann in der Erfassungseinheit 6 erfasst und detektiert. Mit Vorteil kommt die erfindungsgemässe Anordnung der Messschleife 7 ohne zusätzliche und aus dem Stand der Technik bekannte Induktivität aus, so dass ein unkomplizierter und kostengünstig Aufbau der Umrichterschaltung realisiert werden kann, wobei die Umrichterschaltung zudem mit einem geringen Platzbedarf auskommt. Darüber hinaus ist durch die vorstehend beschriebene Anordnung der Messschleife 7 vorteilhaft eine Kurzschlussstromdetektion auch in einer sehr niederinduktiv aufgebauten Umrichterschaltung möglich, ohne dass zusätzlich Induktivitäten eingefügt werden müssen.

In den Ausführungsformen der erfindungsgemässen Umrichterschaltung nach Fig. 2a bis Fig. 4b sind verschiedene Anordnungen der Messschleife 7 gezeigt, wobei bei jeder dieser Ausführungsformen das durch den in der Verschienung 1 und in den Leistungshalbleiterschaltern 4 des zugehörigen Zweigpaares 3 fliessenden Strom I erzeugtes Magnetfeld H die von einer Windung 8 der Messschleife 7 eingeschlossene Fläche A zumindest teilweise durchdringt. Vorzugsweise weist die Messschleife 7 mehrere Windungen 8 auf. Dann durchdringt das Magnetfeld H vorteilhaft von mehreren Windungen 8 eingeschlossene Flächen A, um eine bessere Induktionswirkung bei einer Änderung des Magnetfeldes H bedingt durch einen auftretenden Kurzschlussstrom zu erzielen. Weiterhin ist es denkbar, dass die Messschleifen 7 mehrerer Zweigpaare 3 in Serie oder parallel geschaltet sind.

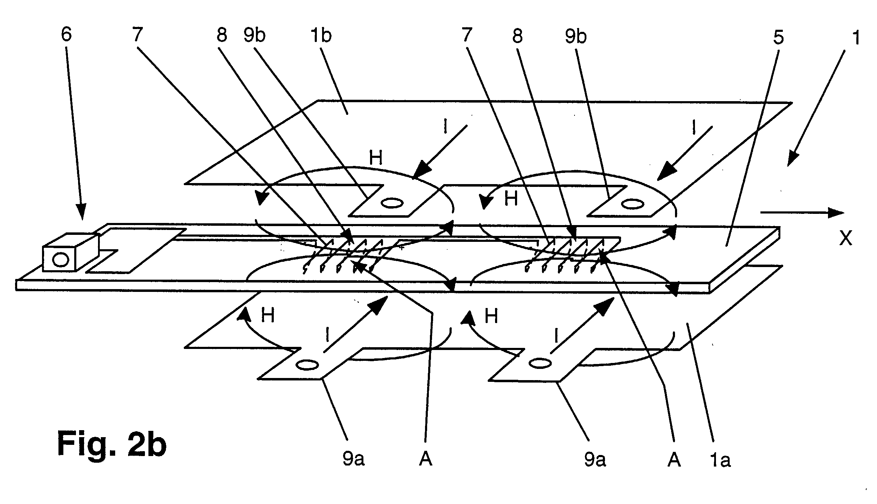

In Fig. 2a ist nun eine Aufsicht eines Ausschnitts einer ersten Ausführungsform der erfindungsgemässen Umrichterschaltung gezeigt. Darin ist die Messschleife 7 vorteilhaft zwischen zwei Verschienungssträngen 1 a, 1 b der Verschienung 1 im Bereich von Verschienungsanschlüssen 9a, 9b der Verschienung 1 für die Leistungshalbleiterschalter 4 des zugehörigen Zweigpaares 3 angeordnet. Die von einer Windung 8 oder von einer der mehreren Windungen 8 der Messschleife 7 eingeschlossenen Fläche A ist in Fig. 2a in dargestellter Weise vom Magnetfeld H durchdrungen. In Fig. 2b ist eine Explosionsansicht des Ausschnitts der ersten Ausführungsform nach Fig. 2a der erfindungsgemässen Umrichterschaltung dargestellt, wobei zwei Messschleifen 7 dargestellt sind, die beispielhaft jeweils mehrere Windungen 8 aufweisen, in Serie geschaltet sind und mit der Auswerteeinrichtung 6 verbunden sind. Weiterhin ist gemäss Fig. 2b jede Windung 8 der Messschleife 7 als Leiterbahn einer Messschleifenleiterplatte 5 ausgebildet. Durch diese Ausbildung der Messschleife 7 kann ein sehr platzsparender Aufbau der Umrichterschaltung erreicht werden, da eine solche Messschleifenleiterplatte 5 eine geringe Bauhöhe aufweist und somit in einfacher Weise zwischen den Verschienungssträngen 1a, 1b angeordnet werden kann. Zudem sind die als Leiterbahnen realisierten Windungen 8 sehr einfach herstellbar. Weiterhin ist die Erfassungseinheit 6 gemäss Fig. 2b vorteilhaft auf der Messschleifenleiterplatte 5 angeordnet. Die Realisierung der Windungen 8 der Messschleife 7 als Leiterbahnen einer Messschleifenleiterplatte 5 und die Anordnung der Erfassungseinheit 6 ist selbstverständlich nicht auf die Ausführungsformen nach Fig. 2a und Fig. 2b beschränkt, sondern kann auch für Messschleifen 7 sämtlicher nachfolgend beschriebener Aüsführungsformen verwendet werden. Gemäss Fig. 2a und Fig. 2b erstreckt sich die Messschleife 7 im wesentlichen senkrecht zu der von einer Windung 8 der Messschleife 7 eingeschlossenen Fläche A und ist bezüglich ihrer Erstreckungsrichtung im wesentlichen längs der Ausdehnungsrichtung X der zwei Verschienungsstränge 1a. 1b der Verschienung 1 ausgerichtet. Dadurch wird eine optimale Durchdringung der Fläche A vom Magnetfeld H erreicht. Es ist auch denkbar, dass die beiden Verschienungsstränge 1a, 1b der Verschienung 1 als Leiterbahnen der vorstehend genannten Leiterplatte 5 ausgeführt sind, wobei die Leiterplatte 5 dann in Mehrschichtechnik ausgebildet ist.

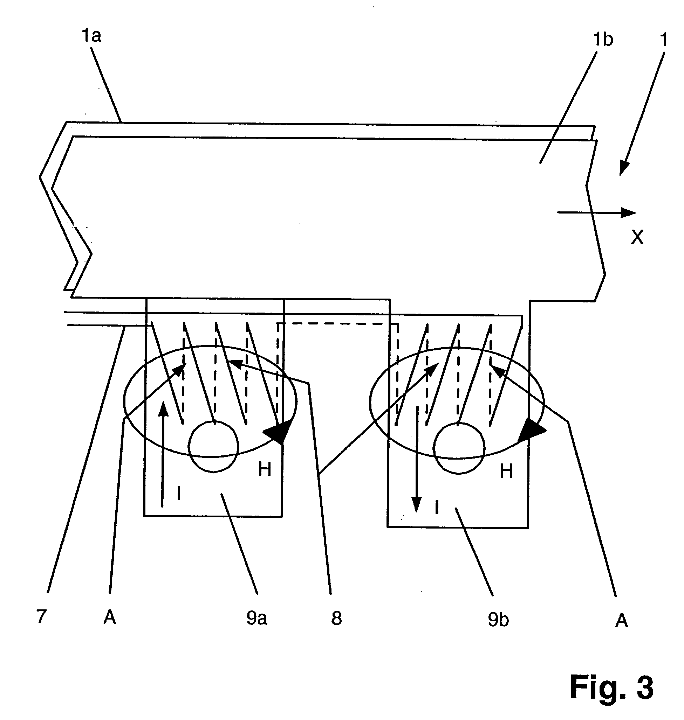

In Fig. 3 ist eine Aufsicht eines Ausschnitts einer zweiten Ausführungsform der erfindungsgemässen Umrichterschaltung gezeigt. Wie bei der Ausführungsform gemäss Fig. 2a sind bei der Ausführungsform nach Fig. 3 zwei Verschienungsstränge 1a, 1b der Verschienung 1 mit jeweils einem im wesentlichen senkrecht zur Ausdehnungsrichtung X des zugehörigen Verschienungsstranges 1a, 1b verlaufenden Verschienungsanschluss 9a, 9b für die Leistungshalbleiterschalter 4 eines jeden Zweigpaars 3 vorgesehen. Die Ausführungsform nach Fig. 3 unterscheidet sich von der Ausführungsform nach Fig. 2a dadurch, dass nun an jedem Verschienungsanschluss 9a, 9b des zugehörigen Zweigpaars 3 ein Teil der Windungen 8 der Messschleife 7 angeordnet ist. Dadurch kann eine weitere Verbesserung der Durchdringung der Fläche A vom Magnetfeld H erzielt werden. Vorzugsweise ist die Anzahl der Windungen 8 an jedem Verschienungsanschluss 9a, 9b des zugehörigen Zweigpaars 3 gleich. Gemäss Fig. 3 erstreckt sich jeder Teil der Windungen 8 der Messschleife 7 im wesentlichen senkrecht zu der von einer Windung 8 des zugehörigen Teils der Windungen 8 der Messschleife 7 eingeschlossene Fläche A, wobei ferner jeder Teil der Windungen 8 der Messschleife 7 bezüglich seiner Erstreckungsrichtung im wesentlichen senkrecht zur Ausdehnungsrichtung des zugehörigen Verschienungsanschlusses 9a, 9b ausgerichtet ist. Weiterhin haben die beiden vorstehend genannten Teile der Windungen 8 der Messschleife 7 einen unterschiedlichen Windungssinn zueinander, wodurch sich die induzierten Spannungen der Teile der Windungen 8 der Messschleife 7 addieren. Alternativ zur Ausführungsform gemäss Fig. 3 ist es aber auch denkbar, dass die Messschleife 7 oder ein Teil der Windungen 8 der Messschleife 7 an nur einem Verschienungsanschluss 9a, 9b angeordnet ist. Eine solche Ausführungsform würde der Ausführungsform gemäss Fig. 3 mit nur einem Teil der Windungen 8 der Messschleife 7 ausschliesslich an nur einem Verschienungsstrang 9a, 9b entsprechen.

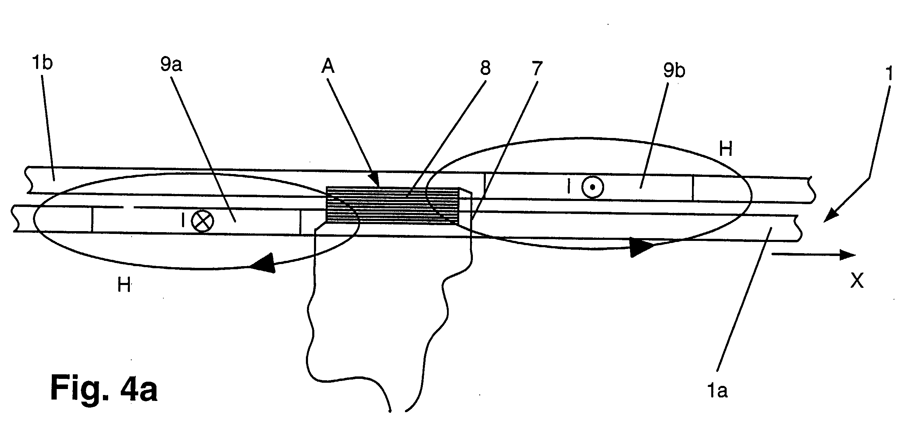

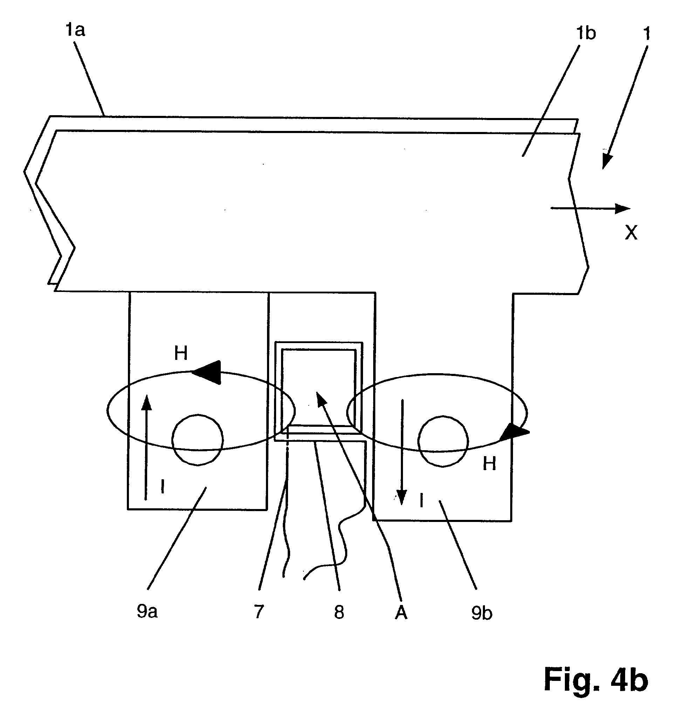

In Fig. 4a ist eine Vorderansicht eines Ausschnitts einer dritten Ausführungsform der erfindungsgemässen Umrichterschaltung gezeigt. In Fig. 4b ist desweiteren eine Aufsicht eines Ausschnitts einer vierten Ausführungsform der erfindungsgemässen Umrichterschaltung dargestellt. Wie bei den Ausführungsformen gemäss Fig. 2a und Fig. 3 sind bei der Ausführungsform nach Fig. 4a, Fig. 4b zwei Verschienungsstränge 1a, 1b der Verschienung 1 mit jeweils einem für die Leistungshalbleiterschalter 4 eines jeden Zweigpaars 3 im wesentlichen senkrecht zur Ausdehnungsrichtung X des zugehörigen Verschienungsstranges 1a, 1b verlaufenden Verschienungsanschluss 9a, 9b vorgesehen. Die Ausführungsform nach Fig. 4a, Fig. 4b unterscheidet sich von den Ausführungsform nach Fig. 2a und Fig. 3 dadurch, dass nun die Messschleife 7 zwischen zwei Verschienungsanschlüssen 9a, 9b für die Leistungshalbleiterschalter 4 des zugehörigen Zweigpaares 3 angeordnet ist. Gemäss Fig. 4a erstreckt sich die Messschleife 7 im wesentlichen senkrecht zu der von einer Windung 8 der Messschleife 7 eingeschlossene Fläche A, wobei die Messschleife 7 weiterhin bezüglich ihrer Erstreckungsrichtung im wesentlichen senkrecht zur der Ausdehnungsrichtung der zwei Verschienungsanschlüssen 9a, 9b ausgerichtet ist. Gemäss Fig. 4b kann sich die Messschleife zur weiteren Platzeinsparung auch in einer Ebene und vorzugsweise parallel zu den beiden Verschienungsanschlüssen 9a, 9b erstrecken, wobei dann die Windungen 8 spiralförmig ausgebildet sind.

Eine weitere, der Übersicht halber nicht dargestellte Ausführungsform der erfindungsgemässen Umrichterschaltung sieht vor, dass, wie bei den vorstehend beschriebenen Ausführungsformen gemäss Fig. 2a bis Fig. 4b, die Verschienung 1 Verschienungsstränge 1a, 1b mit jeweils einem Verschienungsanschluss 9a, 9b für die Leistungshalbleiterschalter 4 eines jeden Zweigpaars 3 aufweist und mindestens eine Leistungshalbleiterschalterleiterbahn innerhalb des Gehäuses eines jeden Leistungshalbleiterschalters 4 mit einem der Verschienungsanschlüsse 9a, 9b des zugehörigen Zweigpaars 3 verbunden ist. Im Unterschied zu den Ausführungsformen gemäss Fig. 2a bis Fig. 4b ist die Messschleife 7 an mindestens einer der mit dem Verschienungsanschluss 9a, 9b verbundenen Leistungshalbleiterschalterleiterbahn angeordnet. Somit kann die Messschleife 7 bereits beim Herstellungsprozess des Leistungshalbleiterschalters 4 in dessen Gehäuse integriert werden, wodurch weiter Platz bezüglich der gesamtem Umrichterschaltung eingespart werden kann. Desweiteren muss die Messschleife 7 nicht mehr separat montiert werden, so dass der Montageaufwand reduziert und Fertigungszeit eingespart werden kann.

Mit sämtlichen vorstehend beschriebenen Anordnungen der Messschleife 7 ist es neben der Detektion eines Kurzschlussstromes auch möglich, eine Strommessung nach dem Rogowski-Prinzip zu realisieren, wobei der danach gemessene Strom beispielsweise zu Überwachungszwecken verwendet werden kann.

Insgesamt ist mit der erfindungsgemässen Umrichterschaltung ein Kurzschlussstrom in einem Zweigpaar 3 der Umrichterschaltung mit sehr wenigen Bauelementen detektierbar. Vorteilhaft ist durch die erfindungsgemässe Anordnung der Messschleife 7 eine solche Detektion stets zuverlässig und vor allem auch für niederinduktiv aufgebaute Umrichterschaltungen möglich. Die erfindungsgemässe Umrichterschaltung ist zudem unkompliziert und kostengünstig aufgebaut und benötigt nur wenig Platz.

### Bezugszeichenliste

- 1: Verschienung
- 1 a, 1b: Verschienungsstrang
- 2: Gleichspannungskreis
- 3: Zweigpaar
- 4: Leistungshalbleiterschälter
- 5: Messschleifenleiterplatte
- 6: Erfassungseinheit
- 7: Messschleife
- 8: Windung
- 9a, 9b: Verschienungsanschluss

## Patentansprüche

1. Umrichterschaltung mit einem für jede Phase (R, S, T) vorgesehenen und über eine Verschienung (1) parallel zu einem Gleichspannungskreis (2) geschalteten Zweigpaar (3), wobei jedes Zweigpaar (3) aus mindestens zwei in Serie geschalteten Leistungshalbleiterschaltern (4) gebildet ist, und
mit einer Einrichtung zur Kurzschlussstromdetektion, wobei die Einrichtung eine Erfassungseinheit (6) und eine für jedes Zweigpaar (3) vorgesehene und mit der Erfassungseinheit (6) verbundene Messschleife (7) aufweist,
**dadurch gekennzeichnet,**
**dass** die Messschleife (7) derart angeordnet ist, dass ein durch einen in der Verschienung (1) und in den Leistungshalbleiterschaltern (4) des zugehörigen Zweigpaares (3) fliessenden Strom (I) erzeugtes Magnetfeld (H) eine von einer Windung (8) der Messschleife (7) eingeschlossene Fläche (A) zumindest teilweise durchdringt.

2. Umrichterschaltung nach Anspruch 1 **dadurch gekennzeichnet, dass** die Messschleife (7) mehrere Windungen (8) aufweist.

3. Umrichterschaltung nach Anspruch 1 oder 2, **dadurch gekennzeichnet, dass** die Messschleifen (7) mehrerer Zweigpaare (3) in Serie geschaltet sind.

4. Umrichterschaltung nach Anspruch 1 oder 2, **dadurch gekennzeichnet, dass** die Messschleifen (7) mehrerer Zweigpaare (3) parallel geschaltet sind.

5. Umrichterschaltung nach einem der Ansprüche 1 bis 4, **dadurch gekennzeichnet, dass** die Messschleife (7) zwischen zwei Verschienungssträngen (1a, 1b) der Verschienung (1) im Bereich von Verschienungsanschlüssen (9a, 9b) der Verschienung (1) für die Leistungshalbleiterschalter (4) des zugehörigen Zweigpaares (3) angeordnet ist.

6. Umrichterschaltung nach Anspruch 5, **dadurch gekennzeichnet, dass** sich die Messschleife (7) im wesentlichen senkrecht zu der von einer Windung (8) der Messschleife (7) eingeschlossene Fläche (A) erstreckt, und
dass die Messschleife (7) bezüglich ihrer Erstreckungsrichtung im wesentlichen längs der Ausdehnungsrichtung (X) der zwei Verschienungsstränge (1a. 1 b) der Verschienung (1) ausgerichtet ist.

7. Umrichterschältüng nach Anspruch 2 oder 4, **dadurch gekennzeichnet, dass** zwei Verschienungsstränge (1a, 1b) der Verschienung (1) mit jeweils einem im wesentlichen senkrecht zur Ausdehnungsrichtung (X) des zugehörigen Verschienungsstranges (1a, 1 b) verlaufenden Verschienungsanschluss (9a, 9b) für die Leistungshalbleiterschalter (4) eines jeden Zweigpaars (3) vorgesehen sind, und
dass an einem oder jedem Verschienungsanschluss (9a, 9b) des zugehörigen Zweigpaars (3) ein Teil der Windungen (8) der Messschleife (7) angeordnet ist.

8. Umrichterschaltung nach Anspruch 7, **dadurch gekennzeichnet, dass** bei Anordnung eines Teils der Windungen (8) an jedem Verschienungsanschluss (9a, 9b) die Anzahl der Windungen (8) an jedem Verschienungsanschluss (9a, 9b) des zugehörigen Zweigpaars (3) gleich ist.

9. Umrichterschaltung nach Anspruch 7 oder 8, **dadurch gekennzeichnet, dass** sich jeder Teil der Windungen (8) der Messschleife (7) im wesentlichen senkrecht zu der von einer Windung (8) des zugehörigen Teils der Windungen (8) der Messschleife (7) eingeschlossene Fläche (A) erstreckt, und
dass jeder Teil der Windungen (8) der Messschleife (7) bezüglich seiner Erstreckungsrichtung im wesentlichen senkrecht zur Ausdehnungsrichtung des zugehörigen Verschienungsanschlusses (9a, 9b) ausgerichtet ist.

10. Umrichterschaltung nach einem der Ansprüche 1 bis 4, **dadurch gekennzeichnet, dass** zwei Verschienungsstränge (1a, 1b) der Verschienung (1) mit jeweils einem für die Leistungshalbleiterschalter (4) eines jeden Zweigpaars (3) im wesentlichen senkrecht zur Ausdehnungsrichtung (X) des zugehörigen Verschienungsstranges (1a, 1b) verlaufenden Verschienungsanschluss (9a, 9b) vorgesehen sind, und
die Messschleife (7) zwischen zwei Verschienungsanschlüssen (9a, 9b) für die Leistungshalbleiterschalter (4) des zugehörigen Zweigpaares (3) angeordnet ist.

11. Umrichterschaltung nach Anspruch 10, **dadurch gekennzeichnet, dass** sich die Messschleife (7) im wesentlichen senkrecht zu der von einer Windung (8) der Messschleife (7) eingeschlossene Fläche (A) erstreckt, und
dass die Messschleife (7) bezüglich ihrer Erstreckungsrichtung im wesentlichen senkrecht zur der Ausdehnungsrichtung der zwei Verschienungsanschlüsse (9a, 9b) ausgerichtet ist.

12. Umrichterschaltung nach Anspruch 10, **dadurch gekennzeichnet, dass** sich die Messschleife 7 in einer Ebene und parallel zu den beiden Verschienungsanschlüssen 9a, 9b erstreckt.

13. Umrichterschaltung nach einem der Ansprüche 1 bis 4, **dadurch gekennzeichnet, dass** die Verschienung (1) Verschienungsstränge (1a, 1b) mit jeweils einem Verschienungsanschluss (9a, 9b) für die Leistungshalbleiterschalter (4) eines jeden Zweigpaars (3) aufweist,
dass mindestens eine Leistungshalbleiterschalterleiterbahn innerhalb des Gehäuses eines jeden Leistungshalbleiterschalters (4) mit einem der Verschienungsanschlüsse (9a, 9b) des zugehörigen Zweigpaars (3) verbunden ist, und
dass die Messschleife 7 an mindestens einer der mit dem Verschienungsanschluss (9a, 9b) verbundenen Leistungshalbleiterschalterleiterbahn angeordnet ist.

14. Umrichterschaltung nach einem der vorhergehenden Ansprüche, **dadurch gekennzeichnet, dass** jede Windung (8) als Leiterbahn einer Messschleifenleiterplatte (5) ausgebildet ist.

15. Umrichterschaltung nach einem der Ansprüche 14, **dadurch gekennzeichnet, dass** die Erfassungseinheit (6) auf der Messschleifenleiterplatte (5) angeordnet ist.
